# Europäisches Patentamt
# European Patent Office
# Office européen des brevets

(19)

(11) Numéro de publication: **0 126 672**
**B1**

(12) **FASCICULE DE BREVET EUROPEEN**

(45) Date de publication du fascicule du brevet:
**11.03.87**

(21) Numéro de dépôt: **84400892.0**

(22) Date de dépôt: **03.05.84**

(51) Int. Cl.⁴: **H 03 H 9/08**

(54) **Résonateur à thermostat infrarouge intégré.**

(30) Priorité: **03.05.83 FR 8307307**

(43) Date de publication de la demande:
**28.11.84 Bulletin 84/48**

(45) Mention de la délivrance du brevet:
**11.03.87 Bulletin 87/11**

(84) Etats contractants désignés:
**CH DE GB LI NL SE**

(56) Documents cités:
**FR - A - 736 956**
**FR - A - 1 438 172**
**FR - A - 2 415 914**
**US - A - 3 121 153**

(73) Titulaire: **ETAT-FRANCAIS représenté par le DELEGUE GENERAL POUR L'ARMEMENT, Bureau des Brevets et Inventions de la Délégation Générale pour l'Armement 14, rue Saint-Dominique, F-75997 Paris Armées (FR)**

(72) Inventeur: **Valentin, Jean Pascal, F-25115 Pouilley Les Vignes (FR)**

ACTORUM AG

# Description

La présente invention concerne un résonateur à thermostat infrarouge intégré, comprenant un boîtier étanche et, à l'intérieur de ce boîtier, un cristal piézoélectrique présentant une partie centrale active sur les faces opposées de laquelle sont déposées des première et deuxième électrodes, et une partie périphérique de support reliée à la partie centrale par des ponts de liaison; des moyens de support de la partie périphérique du cristal à l'intérieur du boîtier; des moyens de chauffage infrarouge; au moins un capteur de température; des réflecteurs pour réfléchir sur le cristal piézoélectrique la chaleur rayonnée par les moyens de chauffage infrarouge; et des conducteurs de liaison entre d'une part lesdites première et deuxième électrodes, le capteur de température et les moyens de chauffage infrarouge, et d'autre part des bornes (21, 22) de raccordement électrique qui traversent le boîtier de façon étanche.

Tous les oscillateurs à quartz de qualité utilisent un résonateur thermostaté. Le résonateur proprement dit est généralement monté sous vide dans un boîtier étanche, qui est lui-même placé à l'intérieur d'un four comprenant une résistance chauffante ou un transistor de puissance et une enceinte conductrice de la chaleur. L'ensemble est isolé de l'extérieur par de la mousse du type polyuréthane ou équivalent, ou par un vase Dewar. La température est régulée en permanence par référence à une tension de consigne. Ce type de thermostat donne des résultats remarquables en stabilité de fréquence. Il a cependant l'inconvénient d'être volumineux, de consommer de l'énergie et d'être assez long à mettre en température. Il est en effet difficile d'obtenir un fonctionnement correct de l'oscillateur en moins d'une heure après la mise sous tension. La puissance nécessaire atteint couramment 15W lors de la période de démarrage pour ensuite se stabiliser à 2 ou 3 watts environ, suivant la température extérieure (de l'ordre de 3W à –50°C et de 2W à + 25°C).

Pour remédier à certains de ces inconvénients, il a été proposé notamment dans le brevet des Etats-Unis d'Amérique n° 3 431 392, de chauffer le cristal de quartz par des couches résistives déposées directement sur le cristal de quartz. Ces couches sont par exemple en nichrome, en tantale, ou en tout autre métal résistif.

Il a aussi été proposé dans les brevets des Etats-Unis d'Amérique n° 2 969 471 et 3 121 153 de chauffer le cristal piézoélectrique par énergie radiante à l'aide de résistances chauffantes disposées entre le cristal de quartz et des réflecteurs concaves.

Ces diverses solutions présentent toutes l'inconvénient d'utiliser des éléments chauffants qui dégazent sous vide et viennent modifier l'atmosphère résiduelle à l'intérieur du capot. Dans ces conditions, le résonateur vieillit mal. Par ailleurs, dans ces diverses solutions le capteur de température utilisé ne donne pas la température de la partie vibrante du résonateur mais une température différente, par exemple celle du bord du résonateur, ou de sa tranche, ou encore celle d'un autre cristal monté symétriquement par rapport au cirstal résonnant. Enfin, les montages mécaniques des solutions utilisant des réflecteurs sont compliqués ou difficiles à réaliser dans la pratique.

La présente invention a pour but de remédier aux inconvénients précités et de réaliser un chauffage par infrarouge, intégré à l'intérieur du boîtier, qui implique une faible consommation, ne dégaze pas et soit facile à mettre en œuvre.

L'invention a encore pour but de réaliser un résonateur à thermostat infrarouge intégré dans lequel le capteur de température est facileà installer et donne une information correspondant à la température de la partie vibrante du cristal.

L'invention vise encore à réaliser un résonateur facile à monter et présentant une suspension mécanique efficace.

Ces buts sont atteints grâce à un résonateur du type défini en tête de la description, dans lequel les réflecteurs sont constitués par des pièces isolantes évidées définissant des calottes sphériques concaves revêtues d'une couche d'un métal réfléchissant et disposées de part et d'autre du cristal, les moyens de chauffage infrarouge sont constitués par de petites ampoules à incandescence basse tension placées de part et d'autre du cristal devant les calottes sphériques; et le capteur de température est constitué par un thermocouple de deux couches minces de métal superposées déposées successivement sur l'une des faces de la partie active du cristal et constituant simultanément l'une des électrodes d'excitation.

De façon plus particulière, le thermocouple comprend une première couche de chrome déposée sur une face de cristal et une seconde couche de nickel déposée sur la première couche de chrome; chacune des couches de chrome et de nickel est associée à un conducteur de liaison, et l'information de tension présente aux bornes des deux conducteurs de liaison est comparée à une tension de référence correspondant à une soudure froide d'un thermocouple classique.

Les calottes sphériques concaves sont avantageusement revêtues d'une couche d'or.

Selon un mode de réalisation particulier, les pièces isolantes définissant les calottes sphériques sont en verre et reposent sur une collerette disposée autour de la partie périphérique du cristal sans contact avec celui-ci, et le cristal est suspendu aux pièces isolantes à l'aide de fils métalliques tendus qui constituent simultanément des conducteurs de liaison avec les électrodes et le thermocouple.

La collerette est revêtue d'une couche d'or sur sa face interne et comporte plusieurs trous de faible diamètre répartis à sa périphérie, destinés à permettre un pompage efficace de l'espace située à l'intérieur de la collerette lors de la mise sous vide du boîtier.

Selon un autre mode de réalisation, des pièces isolantes définissant les calottes sphériques sont réalisées en quartz, et présentent une couple cristallographique identique à celle du cristal; la pièce isolante supérieure s'appuie directement sur la partie périphérique du cristal qui repose elle-même sur la pièce isolante inférieure par l'intermédiaire de billes disposées dans des logements formés dans la surface de la pièce isolante inférieure située en regard de la partie périphérique du cristal.

Les billes sont de préférence au nombre de trois et reposent dans des logements de forme sphérique ou tronconique.

Dans le résonateur selon l'invention, les pièces isolantes supérieure et inférieure peuvent être maintenues assemblées à l'aide de pinces élastiques portant sur des brides périphériques formées sur lesdites pièces.

La pièce peut être fixée sur l'embase du boîtier à l'aide d'un ciment à très faible tension de vapeur.

D'autres caractéristiques et avantages ressortiront de la description qui fait suite de modes particuliers de réalisation de l'invention, en référence aux dessins annexés, sur lesquels:

la fig. 1 représente de façon schématique, en coupe axiale, un résonateur thermostaté à chauffage infrarouge intégré dans le boîtier, selon un premier mode de réalisation de l'invention,

la fig. 2 représente de façon schématique, en coupe axiale, un résonateur thermostaté à chauffage infrarouge intégré dans le boîtier, selon un second mode de réalisation de l'invention,

la fig. 3 montre, vu en perspective, un cristal muni de ses électrodes, utilisable comme résonateur selon l'invention, et

la fig. 4 est une vue en coupe selon la ligne IV-IV de la fig. 3.

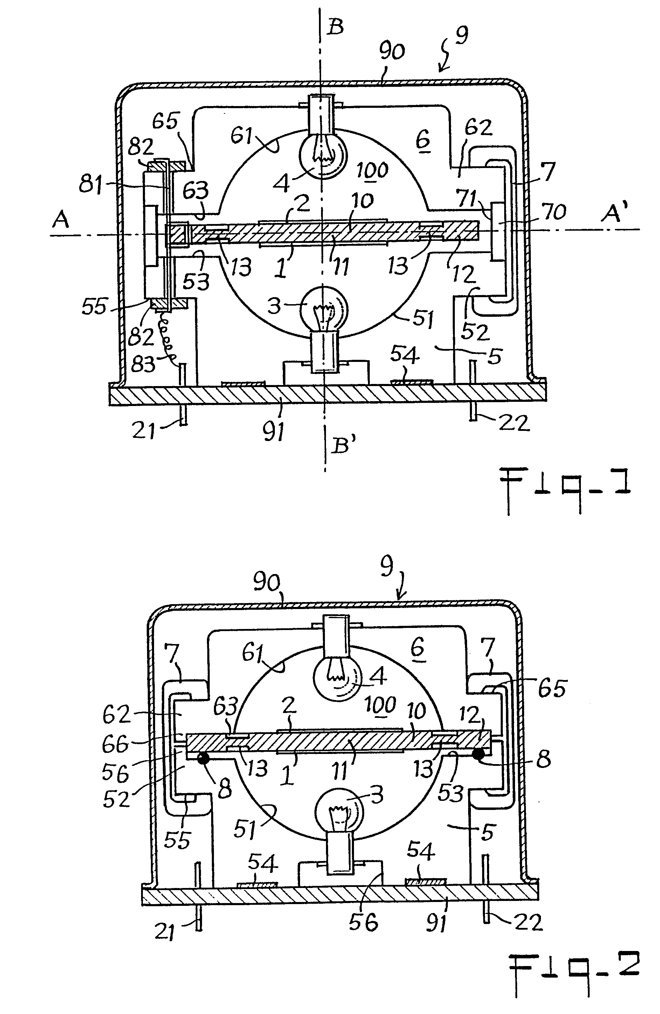

On voit sur la fig. 1 un premier mode de réalisation de résonateur thermostaté conforme à l'invention comprenant un boîtier étanche 9 composé d'une embase 91 et d'un capot 90 scellé sur l'embasse 91. A l'intérieur du boîtier 9 sont montés deux pièces isolantes 5, 6 en verre qui sont évidées pour former chachune une calotte sphérique concave 51, 61 respectivement qui est revêtue d'une mince pellicule d'or la rendant réfléchissante pour les rayonnements infrarouge. La pièce isolante inférieure 5 repose sur l'embase 91 du boîtier 9 et se trouve fixée à celle-ci à l'aide d'un ciment 54 à très faible tension de vapeur. La pièce isolante supérieure 6 repose par sa partie péripherique plane 62 sur une collerette cylindrique 70 également en verre, qui porte elle-même sur la partie périphérique plane 52 de la pièce isolante inférieure 5. La face interne 71 de la collerrette cylindrique 70 est dorée, de même que les faces internes planes 53, 63 des parties périphériques 52, 62 des pièces 5, 6 qui prolongent les calottes sphériques 51, 61. De la sorte, il est réalisé une cavité 100 entièrement réfléchissante délimitée par les pièces isolantes 5, 6 et la collerette cylindrique 70. Cette collerette 70 comporte à mi-hauteur une série de trous de faible diamètre, non représentés sur la fig. 1, qui permettent un pompage efficace de l'intérieur de la cavité 100 lors de la mise sous vide du boîtier 9. Des pinces métalliques 7 enserrent les parties périphériques 52, 62 en forme de brides des pièces isolantes 5, 6 qui définissent les parois réflectrices de la cavité 100.

Des petites ampoules à incandescence basse tension 3, 4 alimentées en parallèle sont fixées dans des orifices ménagés dans les pièces isolantes 5, 6 et émergeant à l'intérieur de la cavité 100. Les ampoules 3, 4 sont symétriques par rapport à un plan médium parallèle à l'embase 91, qui constitue également un plan de symétrie AA' pour les pièces isolantes 5, 6 et la collerette cylindrique 70. Les ampoules 3, 4 sont par ailleurs disposées selon un axe BB' perpendiculaire au plan AA' et passant par le centre de la cavité sphérique 100.

Un cristal de quartz 10 muni d'électrodes 1, 2 pour constituer un résonateur est disposé à l'intérieur de la cavité 100 selon le plan médian AA' de celui-ci. Le cristal 10 présente une partie centrale active 11 sur les faces opposées de laquelle sont déposées des électrodes d'excitation 1, 2. La partie centrale active 11 du cristal 10 est reliée à une partie périphérique 12 en forme de couronne extérieure par l'intermédiaire de ponts de liaison amincis 13, selon une technique connue. La partie centrale active 11 est située au coeur de la cavité sphérique 100 tandis que la couronne extérieure 12 servant à la suspension du cristal 10 est engagée entre les brides 52, 62 des pièces isolantes 5, 6, sans contact avec les faces planes 53, 63 de ces dernières.

Dans le mode de réalisation de la fig. 1, le cristal de quartz 10 est suspendu, d'une manière connue en soi, par des fils métalliques fins 81 engagés dans des trous percés dans la couronne extérieure 12 du cristal 10. Les fils 81, qui peuvent présenter un diamètre de l'ordre de 1 à 2 dixième de millimètre sont tendus et soudés électriquement d'une part sur la couronne 12 du cristal 10 et d'autre part sur des rondelles métalliques 82 disposées sur les faces externes 55, 65 des brides 52, 62 des pièces isolantes 5, 6, dans des positions angulaires décalées par rapport aux pinces 7.

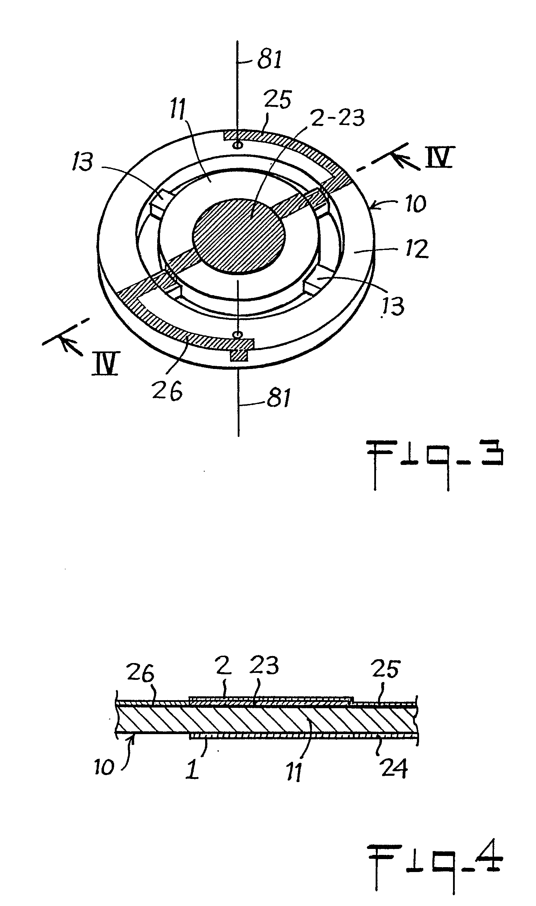

Les électrodes 1, 2 du résonateur sont reliées par des conducteurs de liaison tels que les fils 83 à des bornes 21, 22 qui traversent de façon étanche et isolée électriquement l'embase 91 du boîtier 9. Les conducteurs de liaison peuvent avantageusement être constitués au moins sur une partie de leur trajet par les fils métalliques 81 de suspension du cristal 10, des languettes métallisées 24, 25 formées sur les ponts de liaison 13 et une partie de la couronne extérieure 12 du cristal permettant de relier électriquement les électrodes 1, 2 à des fils de suspension distincts 81 (figure 3 et 4).

L'alimentation électrique des ampoules électriques basse tension 3, 4 n'a pas été représentée sur les figures et peut être réalisée à l'aide de fils conducteurs classiques reliant les culots des ampoules 3, 4 à des bornes isolées montées sur le boîtier 9 d'une façon similaire aux bornes 21, 22.

Les figures 3 et 4 premettent de voir la constitution du capteur de température utilisée pour mesurer la température du cristal 10, et plus particulièrement la température de la partie active 11, afin de permettre l'asservissement de l'alimentation électrique des ampoules de chauffage 3, 4 et contribuer ainsi à la réalisation d'un thermostat complet. Le capteur de température est constitué par un termocouple composé de deux couches métalliques minces 2, 23 déposées successivement sur une face de la partie centrale active 11 du cristal et capables de jouer simultanément le rôle d'électrode d'excitation du cristal. Les deux couches métalliques, qui sont naturellement composées de deux métaux différents peuvent être constituées par une première couche de chrome 23 et une seconde couche de nickel 2 superposée à la couche de chrome 23. Naturellement, d'autres couples de métaux utilisés pour constituer des thermocouples peuvent également être utilisés. Des languettes métalliques 25, 26 déposées sur le cristal 10 relient les deux couches métalliques 23, 2 à des fils de connexion 81 dinsticts et par là-même à des bornes de connexion 21, 22 dinstinctes. La languette métallique 25 sert à la fois au transfert du signal associé à l'électrode 1 dans son ensemble et du signal associé à l'une des couches métalliques (par exemple la couche de nickel 2) tandis que la languette métallique 26 sert au transfert du signal associé à l'autre couche métallique (telle que la couche de chrome 23). Une information de tension différentielle est ainsi disponible sur les bornes de connexion associées aux deux languettes 25, 26. Cette information de tension est comparée à une tension de référence qui remplace l'habituelle soudure dite froide d'un thermocouple. On dispose ainsi d'une information qui est l'image de la température de l'électrode 2, 23. L'électrode 2, 23 étant elle-même en contact avec la partie vibrante 11 du cristal, on dispose ainsi d'une façon très fidèle de l'image de la température de la partie résonante 11 du cristal, sans que la vibration de cette partie résonnante 11 soit perturbée plus que par le dépôt classique d'une électrode adhérente.

La structure de résonateur thermostaté décrite précédemment en référence à la fig. 1 présente un grand nombre d'avantages, outre les avantages propres liés à la présence d'un capteur de température en contact direct avec la partie vibrante 11 du cristal.

Ainsi, le résonateur est bien isolé thermiquement de l'extérieur du fait de sa suspension par fils 81 et du fait qu'il est totalement à l'intérieur d'une cavité réfléchissante 100. On notera que pour l'infrarouge, le facteur énergétique de réflexion de l'or est voisin de 1. Les pertes thermiques sont ici essentiellement des pertes par conduction entre les éléments chauffants 3, 4, la matière qui constitue les réflecteurs 5, 6 et le boîtier 9. Les pertes par conduction sont minimales si on choisit de réaliser les réflecteurs en verre. Dans ces conditions, l'énergie dépensée pour maintenir le résonateur à la température de son point d'inversion (par exemple 80°C) est minimale.

Par ailleurs, le chauffage du résonateur selon l'invention, est plus homogène que dans le cas de résistance déposées à la périphérie 12 du cristal. Ce mode de chauffage est aussi préférable à celui qui utilise des résistances déposées sur des condensateurs associés au cristal 10: en effet, dans ce dernier cas, le chauffage du cristal se fait surtout par les ponts de liaison 13 donc en introduisant un gradient radial de température.

De plus, avec le dispositif selon l'invention, la mise en température du cristal 10 est rapide, les éléments chauffants 3, 4 étant intérieurs, et la seule masse à chauffer est celle du résonateur à l'exclusion de toutes les autres masses thermiques habituellement rencontrées. Ces masses thermiques servent en général de volant d'inertie thermique dans le but de filtrer les fluctuations rapides de température du thermostat, en augmentant la constante de temps thermique de ce dernier. Ici, la constante de temps thermique est réduite. Cependant, elle reste non négligeable du fait de la résistance équivalente de rayonnement entre les ampoules électriques 3, 4 et le résonateur 10. Cette résistance permet d'intégrer les fluctuations rapides de température des éléments chauffants 3, 4, ce qui n'est pas le cas lorsqu'on utilise des couches chauffantes déposées directement à la périphérie 12 du cristal, car il ne reste plus alors que la masse du cristal et sa propre résistance de conduction thermique.

Dans le mode de réalisation de la fig. 1 la suspension par fils 81 réalise en même temps une isolation mécanique du résonateur. Par suite, les déformations du capot 90 ou des réflecteurs 5, 6 ne sont pas transmises au résonateur qui est isolé des variations des contraintes extérieures par la cascade fils 81 – couronne 12 – ponts 13.

En outre, la suspension par fils, et en particulier par quatre fils 81, permet de réaliser une symétrie totale du système de suspension tant par rapport au plan médian AA', passant par le centre du cristal 10 dans l'épaisseur de celui-ci, que par rapport au repère cristallographique du cristal, car quatre points peuvent toujours être distribués symétriquement par rapport à un repère cartésien oxy situé dans le plan du cristal. Dans ces conditions, la sensibilité à l'accélération d'un résonateur ainsi suspendu est minimale et tend vers la sensibilité intrinsèque de la coupe cristalline utilisée.

On décrira maintenant en référence à la fig. 2 un second mode de réalisation qui, comme le premier mode de réalisation précédemment décrit, utilise comme éléments de chauffage deux petites ampoules électriques 3, 4 placées à l'intérieur d'une cavité sphérique 100 délimitée par deux calottes sphériques concaves 51, 62 formées par des revêtements réfléchissants déposés sur des évidements internes de pièces isolantes 5, 6. Les ampoules 3, 4 se trouvent situées de part et d'autre du résonateur constitué par le cristal piézoélectrique 10 muni de ses électrodes d'excitation 1, 2, de la même manière que dans le mode de réalisation précédent. Le capteur de température peut également être réalisé de la même manière que représenté sur la fig. 4, à l'aide d'une paire de couches métalliques superposées formées de deux métaux différents. Le cristal de quartz 10 est lui-même réalisé comme indiqué précédemment, avec une partie intermédiaire à ponts de liaison 13 située en regard de la jonction entre les calottes sphériques 51, 61 et les faces planes internes 53, 63 des pièces isolantes 5, 6.

Le mode de suspension du cristal 10 est cependant différent dans le mode de réalisation de la fig. 2. Ainsi, la pièce isolante supérieure 6 appuie directement par la face plane inférieure 63 de la bride 62 sur la couronne extérieure 12 du cristal 10, tandis que la couronne extérieure 12 du cristal 10 repose elle-même par l'intermédiaire de billes 8 sur la bride 52 de la pièce isolante inférieure 5. Les billes 8 sont de préférence au nombre de trois. Les pinces 7 qui enserrent les brides 52, 62 des pièces 5, 6 sont disposées de manière à exercer une pression de blocage au niveau des billes 8 qui sont positionnées dans des logements sphériques ou tronconiques ménagés dans la surface 53 de la bride 52 de la pièce inférieure 5. Aucune collerette cylindrique indépendante analogue à la collerette 70 de la fig. 1 n'est utilisée, mais les brides 52, 62 se terminent par des nervures non jointives 56, 66 qui entourent la couronne extérieure 12 du cristal 10.

Les billes 8 ont pour rôle d'empêcher la transmission, au niveau du cristal 10, des déformations de la pièce isolante inférieure 5 induites par celles du boîtier 9 qui sont elles-mêmes dues aux variations de température et de pression extérieures. En effet, le contact couronne extérieure 12 – bille 8 est quasi ponctuel. La couronne extérieure 12 du cristal 10 repose donc toujours sur le plan formé par les trois contacts ponctuels des billes 8, quelle que soit la déformée de la pièce isolante inférieure 5. La pièce isolante supérieure 6 est elle-même en contact sur une surface continue avec la couronne 12 du cristal 10. La couronne 12 suit donc totalement la déformée de la pièce supérieure 6. Ceci n'a toutefois pas d'incidence dommageable car cette déformée reste invariable lorsque la température de fonctionnement est atteinte. En particulier, elle ne dépend pas des déformations du boîtier 9, puisque dans le mode de fixation adopté, la pièce supérieure 6 n'est liée au boîtier 9 ni directement, ni même indirectement, les pinces élastiques 7 et les contacts ponctuels par billes 8 jouant un rôle de découplage.

On notera qu'il est souhaitable, lors des variations globales importantes de température, par exemple après un arrêt prolongé, et lors d'une remise en route, de maintenir les dilatations différentielles entre le cristal 10 et les pièces isolantes 5, 6 jouant le rôle de réflecteurs, aussi faibles que possible afin d'éviter l'apparition de défauts de reprise de fréquence et d'hystérésis thermique liés au glissement par sauts des pièces les unes par rapport aux autres. Il est possible d'éviter une telle hystérésis thermique et les inconvénients qu'elle entraîne en taillant les pièces 5, 6 dans du quartz selon une couple cristallographique identique à celle du cristal piézoélectrique 10, et en conservant naturellement l'orientation commune lors du montage du cristal 10 et des pièces 5, 6. On notera que dans ce cas, il est possible d'utiliser du quartz de qualité très médiocre, et donc bon marché, pour réaliser les pièces isolantes 5, 6, celles-ci ne jouant qu'un rôle passif.

La structure décrite en référence à la fig. 2 présente essentiellement l'avantage d'être d'un montage peu délicat et susceptible d'être réalisé rapidement par exemple dans une chaîne de fabrication industrielle. Bien qu'un peu moins bien isolée mécaniquement que le mode de réalisation de la fig. 1, la structure de la fig. 2 présente les mêmes avantages que celle de la figure 1 au point de vue thermique. Les connexions électriques des électrodes 1, 2 et du capteur de température peuvent être réalisées d'une façon similaire à celle représentée sur les figures 3 et 4, si ce n'est que dans le cas du mode de réalisation de la fig. 2, aucune partie des fils de liaison raccordés aux languettes métalliques 24, 25, 26 et aux bornes 21, 22 ne jouent un rôle mécanique.

**Revendications**

1. Résonateur à thermostat infrarouge intégré, comprenant un boîtier étanche (9) et, à l'intérieur de ce boîtier (9), un cristal piézoélectrique (10) présentant une partie centrale active (11) sur les faces opposées de laquelle sont déposées des première (1) et deuxième (2) électrodes, et une partie périphérique de support (12) reliée à la partie centrale (11) par des ponts de liaison (13); des moyens de support de la partie périphérique (12) du cristal à l'intérieur du boîtier (9); des moyens de chauffage infrarouge; au moins un capteur de température; des réflecteurs pour réfléchir sur le cristal piézoélectrique (10) la chaleur rayonnée par les moyens de chauffage infrarouge; et des conducteurs de liaison entre d'une part lesdites première et deuxième électrodes (1, 2), le capteur de température et les moyens de chauffage infrarouge, et d'autre part, des bornes (21, 22) de raccordement électrique qui traversent le boîtier de façon étanche, caractérisé en ce que les réflecteurs (5, 6) sont constitués par des pièces isolantes évidées définissant des calottes sphériques concaves (51, 61) revêtues d'une couche d'un métal réfléchissant et disposées de part et d'autre du cristal; en ce que les moyens de chauffage infrarouge sont constitués par de petites ampoules à incandescence basse tension (3, 4) placées de part et d'autre du cristal (10) devant les calottes sphériques (51, 61); et en ce que le capteur de température est constitué par un thermocouple composé de deux couches minces de métal (2, 23) superposées déposées successivement sur l'une des faces de la partie active (11) du cristal et constituant simultanément l'une (2) des électrodes d'excitation.

2. Résonateur selon la revendication 1, caractérisé en ce que le thermocouple comprend une première couche (23) de chrome déposée sur une face de cristal (10) et une seconde couche (2) de nickel déposée sur la première couche (23) de chrome; en ce que chacune des couches de chrome et de nickel (23, 2) est associée à un conducteur de liaison (26, 25), et en ce que l'information de tension présente aux bornes des deux conducteurs de liaison (26, 25) est comparée à une tension de référence correspondant à une soudure froide d'un thermocouple classique.

3. Résonateur selon la revendication 1 ou 2, caractérisé en ce que les calottes sphériques concaves (51, 61) sont revêtues d'une couche d'or.

4. Résonateur selon l'une quelconque des revendications 1 à 3, caractérisé en ce que les pièces isolantes (5, 6) définissant les calottes sphériques (51, 61) sont en verre et reposent sur une collerette (70) disposée autour de la partie périphérique (12) du cristal (10) est suspendu aux pièces isolantes (5, 6) à l'aide de fils métalliques tendus (81) qui constituent simultanément des conducteurs de liaison avec les électrodes (1, 2) et le thermocouple (2, 23).

5. Résonateur selon l'une quelconque des revendications 1 à 3, caractérisé en ce que les pièces isolantes (5, 6) définissant les calottes sphériques (51, 61) sont réalisées en quartz, et présentent une coupe cristallographique identique à celle du cristal (10); en ce que la pièce isolante supérieure (6) s'appuie directement sur la partie périphérique (12) du cristal (10) qui repose elle-même sur la pièce isolante inférieure (5) par l'intermédiaire de billes (8) disposées dans des logements formés dans la surface de la pièce isolante inférieure (5) située en regard de la partie périphérique (12) du cristal (10).

6. Résonateur selon la revendication 5, caractérisé en ce que les billes (8) sont au nombre de trois.

7. Résonateur selon l'une quelconque des revendications 4 ou 5, caractérisé en ce que les pièces isolantes supérieure (6) et inférieure (5) sont maintenues assemblées à l'aide de pinces élastiques (7) portant sur des brides périphériques (62, 52) formées sur lesdites pièces.

8. Résonateur selon la revendication 7, caractérisé en ce que la pièce isolante inférieure (5) est fixée sur l'embase (91) du boîtier (9) à l'aide d'un ciment (54) à très faible tension de vapeur.

9. Résonateur selon la revendication 4, caractérisé en ce que la collerette (70) est revêtue d'une couche d'or sur sa face interne et comporte plusieurs trous de faible diamètre répartis à sa phériphérie, destinés à permettre un pompage efficace de l'espace situé à l'intérieur de la collerette lors de la mise sous vide du boîtier.

Patentansprüche

1. Resonator mit integriertem Infrarotthermostat, der ein dichtes Gehäuse (9) und im Innern dieses Gehäuses (9) einen Schwingquarz (10) mit einem aktiven zentralen Teil (11), auf dessen gegenüberliegenden Flächen eine erste (1) und eine zweite (2) Elektrode aufgebracht sind, und einem mit dem zentralen Teil (11) durch Verbindungsbrücken (13) verbundenen Umfangsträgerteil (12); Tragelemente für den Umfangsteil (12) des Schwingquarzes im Innern des Gehäuses (9); Infrarotheizelemente; wenigstens einen Temperaturfühler; Reflektoren zur Rückstrahlung der von den Infrarotheizelementen auf den Schwingquarz abgestrahlten Wärme; und Verbindungsleiter zwischen den genannten ersten und zweiten Elektroden (1, 2), dem Temperaturfühler und den Infrarotheizelementen einerseits und den das Gehäuse in dichter Weise durchtretenden elektrischen Anschlussklemmen (21, 22) andererseits umfasst, dadurch gekennzeichnet, dass die Reflektoren (5, 6) aus ausgehöhlten, konkave Kugelkappen (51, 61) definierenden Isolierteilen gebildet werden, die mit einer reflektierenden Metallschicht versehen und beiderseits des Kristalls angeordnet sind; dass die Infrarotheizelemente aus kleinen Niederspannungsglühlampen (3, 4) bestehen, die sich beiderseits des Kristalls (10) vor den Kugelkappen (51, 61), befinden; dass der Temperaturfühler von einem Thermoelement bestehend aus zwei übereinanderliegenden dünnen Metallschichten (2, 23), gebildet ist, die nacheinander auf einer der Flächen des aktiven Teils (11) des Kristalls aufgetragen sind und gleichzeitig eine (2) der Erregerelektroden bilden.

2. Resonator nach Anspruch 1, dadurch gekennzeichnet, dass das Thermoelement eine erste auf einer Kristallfläche (10) aufgetragene Chromschicht (23) und eine zweite Nickelschicht (2) umfasst, die auf der ersten Chromschicht (23) aufgetragen ist; dass jede der Chrom- und Nickelschichten (2, 23) einem Verbindungsleiter (26, 25) zugeordnet ist, und dass die Information der an den Klemmen der beiden Verbindungsleiter (26, 25) anliegenden Spannung mit einer Referenzspannung verglichen wird, die einer Vergleichsstelle eines klassischen Thermoelements entspricht.

3. Resonator nach einem der Ansprüche 1 oder 2, dadurch gekennzeichnet, dass die konkaven Kugelklappen (51, 61) mit einer Goldschicht überzogen sind.

4. Resonator nach einem der vorstehenden Ansprüche 1 bis 3, dadurch gekennzeichnet, dass die die Kugelkappen (51, 61) definierenden Isolierteile (5, 6) aus Glas bestehen und auf einem Kragen (70) aufruhen, der um den Umfangsteil (12) des Kristalls (10), ohne Kontakt mit diesem, angeordnet und an den Isolierteilen (5, 6) mit Hilfe gespannter Metalldrähte (81) aufgehängt ist, die zugleich Verbindungsleiter zu den Elektroden (1, 2) und dem Thermoelement (2, 23) bilden.

5. Resonator nach einem der vorstehenden Ansprüche 1 bis 3, dadurch gekennzeichnet, dass die die Kugelkappen (51, 61) definierenden Isolierteile (5, 6) aus Quarz bestehen und eine Kristallorientierung aufweisen, die mit der des Kristalls (10) identisch ist; dass das obere Isolierteil (6) sich unmittelbar auf dem Umfangsteil (12) des Kristalls (10) abstützt, der seinerseits auf dem unteren Isolierteil (5) über Kugeln (8) aufruht, die in Aufnahmen angeordnet sind, welche in der dem Umfangsteil (12) des Kristalls (10) gegenüberliegenden Fläche des unteren Isolierteils (5) ausgebildet sind.

6. Resonator nach Anspruch 5, dadurch gekennzeichnet, dass drei Kugeln (8) vorgesehen sind.

7. Resonator nach einem der vorstehenden Ansprüche 4 oder 5, dadurch gekennzeichnet, dass das obere (6) und untere (5) Isolierteil mit Hilfe von elastischen Klammern (7) zusammengehalten werden, die sich auf an den vorgenannten Isolierteilen angeformten Umfangsflanschen (62, 52) abstützen.

8. Resonator nach Anspruch 7, dadurch gekennzeichnet, dass das untere Isolierteil (5) auf der Grundplatte (91) des Gehäuses (9) mit Hilfe eines Zements (54) mit sehr geringer Dampfspannung befestigt ist.

9. Resonator nach Anspruch 4, dadurch gekennzeichnet, dass der Kragen (70) auf seiner Innenfläche mit einer Goldschicht überzogen ist und mehrere Löcher geringen Durchmessers aufweist, die über seinen Umfang verteilt und dazu bestimmt sind, ein wirksames Auspumpen des Raumes im Innern des Kragens bei der Evakuierung des Gehäuses zu ermöglichen.

Claims

1. A resonator having an integrated infrared thermostat, comprising: a sealed, vacuum tight casing (9) having therein: a piezoelectric crystal (10) having an actively vibratable central section (11) and linkage bridges (13), to an outer peripheral ring (12); first (1) and second (2) electrodes deposited on opposite surfaces of the central section of the crystal; means for supporting the peripheral ring (12) of the crystal; infrared heating means and reflecting means for reflecting heat from said means onto the crystal (10); at least one temperature sensor; linkage conductors electrically connecting said first and second electrodes (1, 2), the temperature sensor, and the infrared heating means, respectively, with electrical connection terminals (21, 22) which extend in a sealed manner through the casing from its interior to the exterior thereof; wherein each of said reflectors (5, 6) comprises an electrically insulating material having a concave hemispherical dome (51, 61) in one surface thereof, said dome being coated with a layer of reflecting metal, and said reflectors being located on opposite sides of the crystal with the concave metal coated domes facing the crystal; the infrared heating means comprising small, low voltage incandescent electric light bulbs (3, 4), located between each concave reflective dome (51, 61) and the crystal; and the sensor is a thermocouple comprising two thin metal layers (2, 23) superimposed seriatim on one side of the control section (11), of the crystal, at least one of said layers simultaneously comprising an excitation electrode (2) for the crystal.

2. The resonator of claim 1, wherein the thermocouple includes an intial layer (23) of chromium deposited on the crystal (10) and a second layer (22) of nickel deposited on the first layer (23), of chromium, and each of the chromium and nickel layers (23, 2) is connected with a linkage conductor (26, 25), and the voltage datum displays at terminals of said two linkage conductors (26, 25) are connected for comparison to a reference voltage which corresponds to the cold junction of a standard thermocouple.

3. The resonator according to claim 1 or 2, wherein the concave spherical domes (51, 61) are coated with a layer of gold.

4. The resonator according to any of claims 1 to 3, wherein the insulating material (5, 6) of the reflectors is glass, said reflectors rest on a flange (70) located around the peripheral ring (12) of the crystal (10) without being in contact with it, the crystal (10) being suspended between the reflectors by taut metal wires (81) which simultaneously comprise the linkage conductors with the electrodes (1, 2) and the thermocouple (2, 23).

5. The resonator according to any of claims 1 to 3, wherein the insulating material (5, 6) of the reflectors (51, 61) is quartz having a crystallographic section which is identical to that of the crystal (10), and one of the reflectors (6) is located above the other and that upper reflector rests directly on the peripheral ring (12) of the crystal (10) which in turn rests on the lower reflector (5) through spherical supports (8) arranged inside recesses shaped in the surface of the lower reflector (5) facing the peripheral section (12) of the crystal (10).

6. The resonator of claim 5, wherein there are three spherical supports (8).

7. The resonator according to any of claim 4 or 5, wherein the upper (6) and lower (5) reflectors are firmly elastically connected by elastic clamps (7) which bear on a peripheral collar (62, 52) portion of each reflector.

8. The resonator of claim 7, wherein the lower reflector (5) is fastened to the base (91) of the casing (9) by a very low vapor stress cement (54).

9. The resonator of claim 4, wherein the flange (70) is coated with a layer of gold on its inner side and it includes several small diameter holes which are distributed along its periphery, for permitting efficient evacuating of the space located inside the flange during evacuation of the casing.

Fig-1

Fig-2

Fig-3

Fig-4